# DEMANDE DE BREVET EUROPEEN

(11) **EP 2 677 476 A1**
(43) Date de publication de la demande: **25.12.2013**
(21) Numéro de dépôt: 12305709.3
(22) Date de dépôt: 21.06.2012
(51) Int. Cl.: G06K 19/077

(54) **Procédé de connexion par boucle en fil soudé enrobé de matière conductrice et dispositif obtenu**

(71) Demandeur: Gemalto SA, 92190 Meudon (FR)
(72) Inventeur: Seban, Frédérick, 13260 CASSIS (FR); Audouard, Laurent, 13400 AUBAGNE (FR); Ottobon, Stéphane, 83270 SAINT CYR SUR MER (FR)

(57) **Abrégé**

L'invention concerne un procédé de connexion d'un composant électronique et/ou électrique comportant au moins une plage de contact électrique (1, 1A, 21, 22) à au moins un contact électrique externe (2, 32), ledit procédé comprenant l'étape de formation d'au moins une boucle de fil conducteur (4, 14) sur chaque plage de contact du composant, par soudure de fil électrique à ladite plage de contact électrique,
ledit procédé comprenant l'étape selon laquelle pour la connexion, une zone de la boucle est utilisée pour connecter ledit contact externe (2, 32) ;

Il se distingue en ce qu'il comprend une étape de dépôt d'une matière conductrice (42) entre ladite plage de contact électrique (1, 1A, 21, 22) et ledit contact externe (2, 32, 52) de manière à augmenter les surfaces de contact de la boucle avec le contact externe.

L'invention concerne également le dispositif obtenu.

## Description

L'invention concerne un procédé de connexion d'un composant électronique comportant au moins une plage de contact électrique à au moins un contact électrique externe.

Elle concerne notamment un procédé de connexion d'un module à puce de circuit intégré avec au moins une borne de connexion (contact externe) appartenant à un circuit électrique ou à une antenne et disposé sur un substrat.

L'invention concerne plus particulièrement le domaine de la fabrication des cartes à puces et plus particulièrement la connexion de modules électroniques pour cartes à puce capables de fonctionner sans contact à l'aide d'une antenne intégrée dans la carte. Elle peut concerner également des cartes multi composants (afficheur, clavier...) qui requièrent la connexion de module électrique et/ou électronique.

De telles cartes peuvent être destinées à réaliser diverses opérations, telles que, par exemple, des opérations bancaires, des communications téléphoniques, des opérations d'identification, des opérations de débit ou de rechargement d'unités de compte, et toutes sortes d'opérations qui peuvent s'effectuer à distance par couplage électromagnétique à haute fréquence entre une borne d'émission-réception et une carte placée dans la zone d'action de cette borne.

Un des problèmes techniques principaux qu'il faut résoudre dans la fabrication de telles cartes est la connexion de l'antenne à une puce de circuit intégré qui assure un fonctionnement électronique de la carte. Les contraintes classiques de tenue mécanique, de fiabilité et de coût de fabrication doivent être prises en compte dans cette fabrication.

On connait le brevet FR 2761527 décrivant la réalisation de pattes de connexion filaires par portion de fil soudé directement sur les plots électriques de puces de circuits intégrés. Ce document décrit de connecter avec le même fil, deux plots distincts d'une même puce ou de puces différentes adjacentes sur une galette de semi-conducteur puis de scier les fils en leur milieu au cours notamment de la séparation des puces entre-elles. La connexion des puces à une antenne s'effectue ensuite par tout moyen de connexion par soudure à chaud ou à froid des portions résiduelles de fils à des portions terminales d'une antenne.

En d'autres mots, ce brevet utilise la technique très classique de "wire-bonding", «ball-bonding», ou soudage de fil par thermo-compression, c'est-à-dire de soudage de fil (en général d'or ou d'aluminium) sur une puce, mais au lieu d'utiliser cette technique de la manière habituelle, c'est-à-dire en faisant partir un fil depuis un plot de contact de la puce pour l'amener jusqu'à un plot de contact d'un élément de support de puce (habituellement une grille de connexion ou un module de circuit imprimé), il est prévu de souder une extrémité du fil sur un plot de contact de la puce mais sans souder l'autre extrémité sur un élément extérieur sur lequel la puce serait reportée. Le fil reste libre pour servir d'élément de contact en saillie au-dessus de la puce.

Les procédés de l'art antérieur pour le domaine de la carte à puce requièrent des opérations additionnelles et des machines spécifiques notamment des équipements de dispense colle ou de formation de bossages qui viennent s'ajouter à des équipements normaux de connexion de la puce et de report de module.

La demande de brevet EP2386986 a notamment pour objectif d'éviter un poste de dépôt de colle conductrice. Il décrit un procédé de réalisation sur chaque contact électrique des bossages élastiques conducteurs (bumps) en forme de boucle par technique de fil conducteur soudé; La connexion s'établit ensuite par simple pression de contact entre la boucle et une surface conductrice à connecter.

Ce dernier procédé avec celui de connexion par colle conductrice peuvent poser un problème de rebut lors de la production et un problème de perte de connexion lors de tests mécaniques de fiabilité poussés ou de durabilité sur le terrain.

En particulier, dans le cas d'antenne comportant des spires en fil conducteur déposées dans un plan, il est souhaité d'avoir des extrémités de connexion en forme de zigzag ou forme équivalente (spirale, alternances...) permettant d'étendre la surface de connexion à un module de carte à puce. Il peut arriver que des boucles ne touchent pas les contacts externes par exemple par manque de longueur ou parce que le sommet des boucles se place entre les alternances des zigzags; Dans certains cas, la boucle peut se déplacer en dehors du diamètre du fil à connecter notamment au cours d'une flexion / torsion d'une carte à puce.

L'invention vise à résoudre les inconvénients précités. Elle vise aussi à augmenter la fiabilité des connexions électriques notamment avec des antennes en fils incrustés.

Le principe de l'invention est de combiner un procédé de connexion par boucle de fils conducteurs avec un procédé de connexion par matière conductrice afin d'améliorer la fiabilité de cette connexion. L'invention prévoit donc de réaliser sur chaque plage de contact, des bossages élastiques conducteurs (bumps) en forme de boucle par technique de fil conducteur soudé puis à utiliser un dépôt de colle conductrice au niveau de chaque boucle et contact externe à connecter, la matière enrobant le contact externe et au moins une partie de la boucle.

L'invention combine une première solution technique de connexion par boucle conductrice avec une solution de connexion par matière conductrice qui était à priori écartée par la première solution.

Selon un mode de mise en oeuvre, les boucles de fils conducteurs d'or ou l'aluminium ou encore de cuivre peuvent être plongées dans la matière conductrice lors de l'encartage du module. Lors de la polymérisation (durcissement) de celle-ci les fils conducteurs sont emprisonnés et intimement en contact des particules conductrices de la matière conductrice. De plus, ces boucles de fils, de part leur souplesse et leur élasticité, rentrent en contact avec le contact externe.

La rigidité et fiabilité de la connexion vient de la polymérisation de la colle conductrice emprisonnant les boucles qui en se croisant, pardessus pour l'un, dessous pour l'autre forment une structure particulière. Le lien ainsi créé entre le module et le contact externe est ainsi hautement amélioré.

A cet effet, l'invention a pour objet un procédé de connexion d'un composant électronique et/ou électrique comportant au moins une plage de contact électrique à au moins un contact électrique externe, ledit procédé comprenant l'étape de formation d'au moins une boucle de fil conducteur sur chaque plage de contact du composant, par soudure de fil électrique à ladite plage de contact électrique,
ledit procédé comprenant l'étape suivant selon laquelle pour la connexion, une zone de la boucle est utilisée pour connecter ledit contact externe ;
Le procédé se distingue en ce qu'il comprend une étape de dépôt d'une matière conductrice entre ladite plage de contact électrique et ledit contact externe de manière à augmenter les surfaces de contact de la boucle avec le contact externe.

Selon d'autres caractéristiques de l'invention,
- Le contact électrique externe est formé par un parcours de fil conducteur notamment en zigzag ou équivalent de manière à offrir une surface de connexion plus large que la largeur du fil;
- On réalise plusieurs boucles par contact électrique et la matière conductrice emprisonne et relie électriquement les boucles entre elles;
- La matière conductrice peut être déposée sur les contacts externes ou sur les boucles préalablement au report du module dans une cavité.

L'invention a également pour objet un dispositif correspondant obtenu par le procédé et un produit électronique de communication radiofréquence, tel une carte à puce sans-contact, comprenant ou formant le dispositif.

L'invention a également pour avantage d'éviter une corrosion qui s'établirait entre les boucles et les contacts, par exemple dans le cas où les boucles sont réalisées en fils de cuivre.

D'autres particularités et avantages de l'invention apparaîtront à la lecture de la description, qui suit, donnée à titre d'exemple illustratif et non limitatif, et faite en référence aux figures annexées pour lesquelles :
- les figures 1 et 2 illustrent une vue schématique partielle de dispositif de l'art antérieur en cours d'assemblage selon un premier et second mode de mise en oeuvre;
- la figure 3 relative à l'art antérieur, illustre une vue d'un module électronique de type carte à puce en vue de dessous, ledit module comportant les deux types d'élément de connexion en étant agencés croisés ou non;
- la figure 4 illustre une vue en coupe d'un module conforme à la figure 3 mais avec une seule boucle par plage de contact;
- La figure 5 illustre une vue en coupe d'une carte à puce comportant le module de la figure 4 connectée à une antenne ;
- Les figures 6-8 illustrent des étapes de mise en oeuvre de l'invention selon un mode préféré.

L'invention reprend la description des différents modes de réalisation illustrés de l'art antérieur, puisqu'elle peut les mettre en oeuvre en combinaison avec une autre étape de dépôt de matière conductrice décrite ultérieurement.

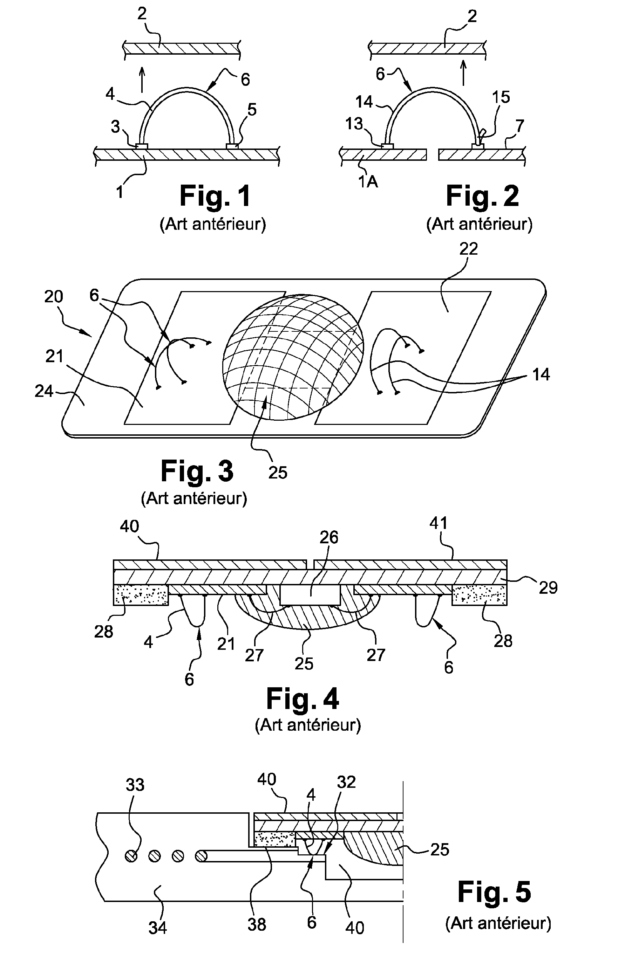

A la figure 1, au moins une plage de contact électrique 1 d'un composant électronique (non représenté) est destinée à connecter au moins un contact électrique externe 2 d'un dispositif quelconque (non représenté); ce dernier contact 2 peut appartenir à tout dispositif distinct du composant 1. Le procédé comprend un étape de formation d'au moins un élément de connexion souple 4 sur chaque plage de contact 1 du composant par soudure d'une première extrémité 3 d'une portion de fil électrique 4 à la plage de contact électrique du composant 1,
Dans l'exemple on utilise avantageusement la technologie de fil soudé du type "wire, edge ou ball bonding"
D'autres technologies sont utilisables comme la thermo compression ou dépôt de fil non isolé par ultrasons.

Le procédé peut comporter une étape de fixation / recourbement d'une seconde extrémité 5 du fil (opposée à la première extrémité 3) sur une surface externe du même composant. Ce recourbement est effectué de manière à offrir une boucle conductrice entre les deux extrémités de fil et une zone de contact 6 sur une périphérie externe de la boucle;

Selon un premier mode de mise en oeuvre, la fixation de la seconde extrémité 5 de la portion de fil est effectuée par soudure du fil à la même plage de contact 1. La zone de contact 6 du fil (portion bombée externe de la boucle ou rayon de courbure externe) est de préférence destinée à connecter le contact électrique externe 2 par simple pression de contact au cours d'un simple rapprochement entre eux (symbolisé par la flèche). L'élément de connexion 4 viendra ensuite se déformer élastiquement contre la plage de contact 2 au cours de ce rapprochement.
Grâce à l'étape supplémentaire de l'invention visée ultérieurement, la tolérance dimensionnelle sur la hauteur de boucle peut être plus large.

A la figure 2, les éléments portant les mêmes numéros qu'à la figure 1 sont identiques; on fixe un fil conducteur 14 par une extrémité 13 sur une plage de contact 1A d'un composant et on procède de la même manière que précédemment sauf pour la seconde extrémité qui est fixée à une surface distincte de la plage de contact 1A. Ici cette surface 7 est un isolant électrique. La fixation peut être réalisée par tout moyen (mécanique, adhésif, soudure à chaud ou froid dans le cas où la surface est conductrice comme à la figure précédente)

Aux figures 3 et 4, le composant est un module sans-contact 20 pour carte à puce de type "combi" à interface duale (à contacts et sans-contact). Il comporte deux plages de contact électrique 21, 22 sur un substrat diélectrique 24 et un enrobage 25 d'un microcircuit électronique 26 relié aux plages de contact par des connexions 27 de type fil soudé. Il comprend également un ensemble de plages de contact électrique externes 40, 41 selon la norme ISO 7816 pour communiquer avec un terminal de type à contacts électriques.

Le module de la figure 3 comprend plusieurs éléments ou zone de connexion 6 sur chaque plage de contact 21 , 22 formés respectivement comme sur les figures 1 et 2. Sur la plage 21, les fils sont croisés au sommet tandis que pour la plage 22, les fils ne se croisent pas. Contrairement à la figure 2, l'extrémité 15 est fixée sur la même plage de contact 22. Cette extrémité est une simple soudure contrairement à la fixation des extrémités 13, 3 et 4 qui comprennent un point de soudure plus étendu (type « ball bonding »).

De manière avantageuse, chaque élément de connexion 4, 14 (ou boucle) est formé au cours d'une étape de raccordement des plots du microcircuit électronique 26 (comprenant ici une puce de circuit intégré) aux deux plages de contact 21, 22 du module électronique 20. Cela signifie que l'on peut effectuer ces éléments de connexion 4, 14 avec un équipement existant, au même poste de travail et/ou avec la même tête de soudure que celui et/ou celle utilisé(s) pour connecter la puce de circuit intégré au module.

Alternativement, le module peut être destiné à connecter un des contacts d'un circuit réalisé sur un circuit imprimé ou autre support flexible. C'est par exemple le cas d'une carte multi composant (à afficheur, clavier...)

A la figure 5, on a représenté un exemple de connexion d'un composant à des contacts électriques d'un dispositif conformément à un mode de mise en oeuvre de l'invention (mais sans l'étape préalable) de dépôt de matière conductrice susmentionnée qui devra être prévue pour une connexion plus fiable selon l'invention.

Les contacts externes sont ici constitués par des plages de contacts terminales 32 d'une antenne 33 à plusieurs spires noyées dans un corps 34 de carte à puce. Le composant est représenté par le module de la figure 4 qui se trouve sur la figure 5 dans un état de report dans une cavité 40 du corps de carte et de raccordement électrique à l'antenne 33. L'antenne est réalisée en fil incrusté et subit un usinage aux bornes pour être dénudé à l'occasion de la formation des différents plans constituant la cavité

Préalablement à l'encartage du module, ce dernier comporte un film adhésif 28 de type thermo adhésif fixé au moins sur une périphérie du module et dont la surface correspond à une surface de collage équivalente 38 présente dans la cavité.

Le raccordement électrique du module à l'antenne s'effectue comme à la figure 1 en rapprochant les contacts à connecter. Pour cela le module est reporté dans une cavité 40 de corps de carte, les éléments de connexion 6 peuvent de préférence venir se déformer élastiquement contre les plages de contact 32 de l'antenne et connecter par simple pression de contact lesdites plages électriques externes 32. Le film adhésif 28 est notamment activé préalablement par UV ou infrarouge ou postérieurement au report par transfert thermique et pression.

Conformément à un quelconque des modes de réalisation de l'invention, le procédé prévoit de disposer une matière conductrice entre les plages externes 2, 32 des figures 1- 5 et les plages de contact électriques 1, 1A, 21 , 22. Cette matière est de préférence une colle conductrice qui se solidifie après dépôt, notamment par polymérisation, à air, aux ultra-violets, etc.
La matière s'étend sur le contact externe 2, 32 tout en étant au contact d'au moins une des boucles 4, 14 ou toutes les boucles d'une même connexion. La matière conductrice peut également s'étendre à la totalité de la hauteur des boucles de fils de façon à être en contact avec l'antenne 52 et le plot 21.
Grâce à cette matière conductrice, la hauteur des boucles n'a pas besoin d'être aussi précise ou venir se déformer contre le contact externe 2, 32 qui lui correspond.
On améliore également la tenue mécanique de la connexion ainsi formée (boucle de fil dans matière conductrice polymérisée) lors des sollicitations mécaniques de la carte sur le terrain.

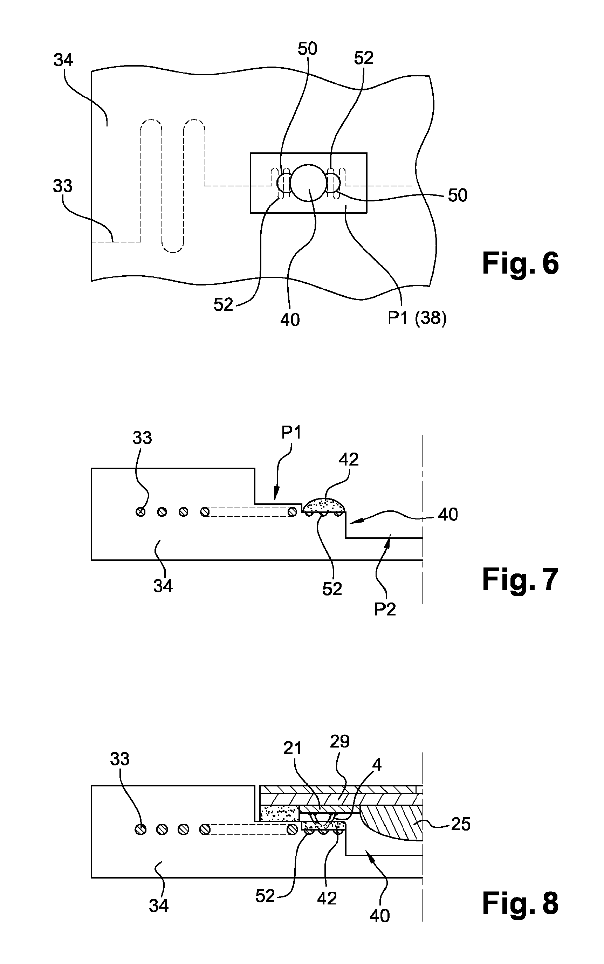

Selon le mode préféré, à la figure 6, on réalise une antenne 33 ou un circuit électrique comme sur la figure 5 sur un support 34 de même type avec comme différence celle d'avoir des contacts électriques externes 52 (externes au module) qui comportent un motif de connexion élargi (par exemple en zigzag) pour faciliter la connexion avec au moins une boucle du module.

Le corps peut comprendre plusieurs cavités présentant un plan P1 (38) de collage du module, une cavité 40 de réception de la puce et de son enrobage éventuel présentant un plan P2, des cavités 50 d'accès aux contacts notamment filaires et en en zigzags. Ces cavités sont réalisées notamment par usinage. L'usinage des cavités 50 d'accès aux contacts électriques externes peut usiner également partiellement les portions de fil du zigzag pour les dénuder de manière connue.

A la figure 7, conformément à ce mode de mise en oeuvre de l'invention, on place une matière conductrice entre le contact électrique 52, ici en zigzag, et une plage de contact 21 , 22. Dans l'exemple, on effectue un dépôt d'une goutte 42 de la matière conductrice directement sur le contact électrique 52.

Alternativement, le procédé de l'invention peut prévoir de tremper les boucles du module dans de la matière conductrice avant de reporter le module dans sa cavité.

Alternativement encore, le procédé de l'invention selon l'un quelconque de modes de réalisation, peut prévoir d'effecteur les boucles sur les contacts externes, voire sur les zigzags (ou équivalent), la matière conductrice étant au contact de la plage de contact électrique 1, 1A, 21, 22.

A la figure 8, selon le mode préféré, le procédé prévoit de reporter le module comme à la figure 5 dans une cavité de corps de carte. Les boucles sont alors noyées par au moins leur sommet arrondi dans la matière conductrice.
Au préalable, le procédé peut prévoir une étape de polymérisation de la matière conductrice juste avant le report du module.

Le cas échéant, on peut effectuer des puits d'accès 50 que l'on remplit totalement de manière à noyer complètement les boucles.

Au moins, le sommet des boucles est pris dans la matière conductrice après solidification assurant ainsi un contact qui peut être selon le mode préféré, à la fois rigide aux extrémités et flexible au milieu. Il s'en suit une connexion électrique plus fiable avec les contacts électriques 2, 32, 52.

Ainsi, l'invention permet d'allier l'avantage de réalisation d'une connexion souple filaire (sur le même poste de connexion filaire que celui de connexion de la puce) avec une fiabilité de connexion accrue pour notamment des antennes filaires connues pour de bonnes performances radiofréquences ou pour des circuits filaires réalisés sur un substrat quelconque.

## Revendications

1. Procédé de connexion d'un composant électronique et/ou électrique comportant au moins une plage de contact électrique (1, 1A, 21 , 22) à au moins un contact électrique externe (2, 32), ledit procédé comprenant l'étape de formation d'au moins une boucle de fil conducteur (4, 14) sur chaque plage de contact du composant, par soudure de fil électrique à ladite plage de contact électrique,
ledit procédé comprenant l'étape suivant selon laquelle pour la connexion, une zone de la boucle est utilisée pour connecter ledit contact externe (2, 32),
**caractérisé en ce qu'**il comprend une étape de dépôt d'une matière conductrice (42) entre ladite plage de contact électrique (1, 1A, 21, 22) et ledit contact externe (2, 32, 52) de manière à augmenter les surfaces de contact de la boucle avec le contact externe.

2. Procédé selon la revendication 1, **caractérisé en ce que** le contact électrique externe (52) est formé par un parcours de fil conducteur notamment en zigzag ou équivalent de manière à offrir une surface de connexion plus large que la largeur du fil.

3. Procédé selon la revendication 1, **caractérisé en ce qu'**il comprend plusieurs boucles (4, 14) par contact électrique et la matière conductrice emprisonne et relie électriquement les boucles entre elles.

4. Procédé selon la revendication précédente, **caractérisé en ce que** le composant est un module sans contact (20) comportant deux plages de contact électrique (21, 22).

5. Procédé selon l'une quelconque des revendications précédentes, **caractérisé en ce que** pour la connexion aux contacts électriques externes (2, 32), on reporte et fixe le module (20) dans une cavité de corps de carte, les éléments de connexion (4) venant se déformer élastiquement contre les plages de contact électrique externes (32) et/ou venant au contact du dépôt de ladite matière conductrice.

6. Procédé selon l'une quelconque des revendications précédentes, **caractérisé en ce que** chaque plage de contact comporte plusieurs éléments de connexion se croisant ou non.

7. Procédé selon l'une des revendications précédentes, **caractérisé en ce que** la matière conductrice est déposée sur les contacts externes ou sur les boucles préalablement au report du module dans la cavité.

8. Dispositif comprenant un composant électronique comportant au moins une plage de contact électrique (1, 1A, 21 , 22) connectant au moins un contact électrique externe (2, 32),
- au moins une boucle de fil conducteur sur chaque plage de contact du composant, par soudure d'une portion de fil électrique à ladite plage de contact électrique,
- une zone de contact externe (6) de la boucle connectant ou avoisinant ledit contact externe (2, 32),
**caractérisé en ce qu'**il comprend une matière conductrice située au contact de chaque boucle entre chaque plage de contact électrique (1, 1A, 21, 22) et ledit contact électrique externe (2, 32) de manière à augmenter les surfaces de contact de la boucle avec le contact externe.

9. Produit électronique de communication radiofréquence, tel une carte à puce sans-contact, comprenant ou formant le dispositif selon la revendication précédente.
